**Europäisches Patentamt**

**European Patent Office**

**Office européen des brevets**

(11) Publication number:

**0 109 766**
**B1**

## (12) EUROPEAN PATENT SPECIFICATION

(45) Date of publication of patent specification: **30.12.86**

(51) Int. Cl.⁴: **H 01 L 23/28, H 01 L 21/318**

(21) Application number: **83306396.9**

(22) Date of filing: **21.10.83**

(54) Semiconductor device with a passivated junction.

(30) Priority: **22.10.82 JP 185510/82**

(43) Date of publication of application:
**30.05.84 Bulletin 84/22**

(45) Publication of the grant of the patent:
**30.12.86 Bulletin 86/52**

(84) Designated Contracting States:
**DE FR GB**

(56) References cited:
**GB-A-1 192 144**
**US-A-3 597 667**
**US-A-4 157 269**

**IBM TECHNICAL DISCLOSURE BULLETIN, vol.
18, no. 3, August 1975, New York I. ANTIPOV
"Filling air pockets in undercut areas beneath
silicon nitride", page 732**

(73) Proprietor: **FUJITSU LIMITED**
**1015, Kamikodanaka Nakahara-ku**
**Kawasaki-shi Kanagawa 211 (JP)**

(72) Inventor: **Goto, Hiroshi c/o FUJITSU LIMITED**
**Patent Department 1015 Kamikodanaka**
**Nakahara-ku Kawasaki 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

## Description

The present invention relates to a semiconductor device.

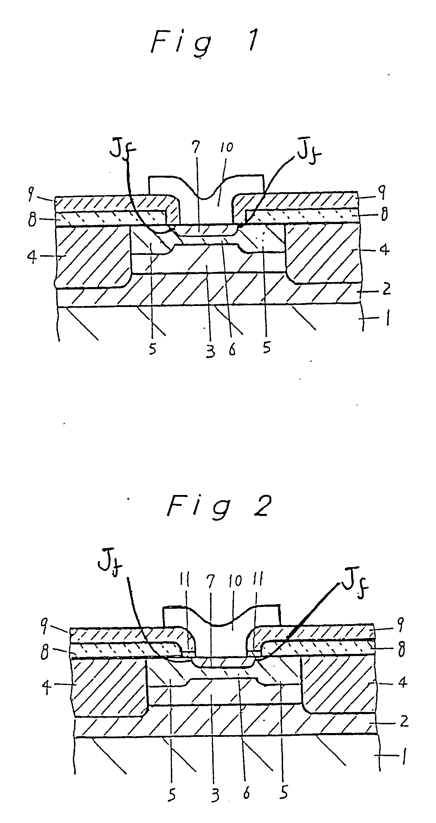

Figure 1 is a schematic cross-sectional view of an Iso planar self-aligned transistor as previously fabricated. An Iso planar transistor is an oxide isolated planar transistor which has a buried layer for connecting the collector operationally to the collector electrode on the surface of the device, or to other circuit elements (not shown).

Figure 1 shows only significant parts of the self-aligned transistor structure. In Figure 1, 1 is a p type silicon substrate, 2 is a n type buried layer, 3 is a collector region made of a n type epitaxial layer grown on the buried layer. 4 is a field oxide layer, 5 is a $p^+$ (highly doped with p type conductivity impurities) type base contact region, 6 is a p type active base region, 7 is a $n^+$ (highly doped with n type conductivity impurities) type emitter region, 8 is a p type base electrode made of polysilicon (polycrystalline silicon), 9 is a thermal oxide layer of polysilicon, and 10 is an emitter electrode.

As can be seen in Figure 1, the periphery of the base-emitter junction, indicated by $J_f$, is terminated at the edge of thermal oxide layer 9, which separates the emitter electrode 10 from the polysilicon base contact 8.

A thermal oxide layer of polysilicon is porous, and its surface state is unstable compared to that of a chemically deposited oxide layer or of a silicon nitride film. Hence a slight leakage current or a degradation of break down voltage between the emitter and the base inevitably occurs for the self aligned transistor of Figure 1. There are also problems of production yield and device reliability.

Similar problems can arise in other types of transistor, affecting stability.

GB—A—1 192 144 discloses a semiconductor device, comprising an active base region, an emitter region formed in the active base region, to provide a base-emitter junction having a perimeter at a surface in the device, and a silicon nitride film formed on the surface to cover the perimeter of the base-emitter junction.

According to one aspect of the present invention there is provided a semiconductor device, comprising an active base region, an emitter region formed in the active base region, to provide a base-emitter junction ($J_f$) having a perimeter at a surface in the device, and a silicon nitride film formed on the surface to cover the perimeter of the base-emitter junction ($J_f$), characterised by a base contact area connected to the active base region, a base contact electrode, of polysilicon, formed on the base contact area, and an oxide layer formed by surface oxidation of the base contact electrode, for isolating the base contact electrode from an emitter electrode, the oxide layer terminating on the silicon nitride film.

According to another aspect of the present invention there is provided a method of fabricating a semiconductor device having an emitter electrode separated from a base contact electrode, of polysilicon, by a thermally oxidised polysilicon layer; the method comprising the following steps:—

a) coating a surface of a first conductivity type region of the device with a first silicon nitride film;

b) forming, in turn, on the surface of the first silicon nitride film a first silicon dioxide film and a second nitride film;

c) patterning the second silicon nitride film to expose a part of the first silicon dioxide film;

d) etching off the exposed part of the first silicon dioxide film, to thereby expose part of the first silicon nitride film, at the same time side etching the first silicon dioxide film beneath the patterned second silicon nitride film;

e) etching off the exposed part of first silicon nitride film which is not beneath the patterned second silicon nitride film;

f) providing a highly doped polysilicon layer of a second conductivity type on the surface of the patterned second silicon nitride film and on surface parts of the said device region that are exposed in step e);

g) etching off the remainder of the first silicon dioxide film, at the same time lifting off the patterned second silicon nitride film and the part of the polysilicon layer thereon;

h) providing by thermal oxidation a silicon dioxide layer on the surface of the remaining part of the polysilicon layer and terminating on the first silicon nitride film, at the same time diffusing impurities from the polysilicon layer into the said device region of the first conductivity type, to provide a base contact region of the second conductivity type;

i) selectively implanting impurities of the second conductivity type, by ion implantation, through the first silicon nitride film, into said device region using as a mask the polysilicon layer having the thermal oxidised silicon dioxide layer thereon;

j) selectively etching off the first silicon nitride film where exposed by the polysilicon layer having the thermally oxidised silicon dioxide layer thereon;

k) selectively implanting impurities of the first conductivity type by ion implantation into the zone of the said device region where impurities of the second conductivity type were implanted in step i) using as a mask the polysilicon layer having the thermal oxidised silicon dioxide layer thereon; and

l) annealing the ion implanted impurities of first and second conductivity types, by heat treatment, to form an active base region which is of the second conductivity type and which extends to contact the base contact region, and an emitter region of the first conductivity type which extends underneath the remaining part of the first silicon nitride film so that the perimeter of the base-emitter junction at the surface of the said device region is covered by that remaining part of the first silicon nitride film.

An embodiment of one aspect of the present invention can provide a semiconductor device the performance of which is stable and the production yield of which is high. An embodiment of another aspect of the present invention can provide a method of fabricating such a device.

Embodiments of the present invention are applicable to bipolar transistors, and are particularly effective for self-aligned planar transistors, base contact electrodes of which are made from polysilicon material.

A transistor fabricated in accordance with an embodiment of the present invention has a self aligned base electrode, base contact area, active base region and an emitter region. It offers improvement as regards the passivation of the base-emitter junction, at its periphery at the surface of a substrate of the transistor.

Embodiments of the present invention are applicable to semiconductor devices which use any type of isolation technique, such as conventional, Iso planar or LOCOS (Local Oxidation of Silicon) isolation for example.

Embodiments of the present invention are particularly applicable for stabilising the performance of self-aligned transistors.

A self-aligned transistor is a transistor whose emitter or base is fabricated using a self-alignment technique. For example, the base and emitter (in many cases the contact electrodes for the base and emitter also) are fabricated using a single lithographic mask. It is necessary neither to use a specific mask for each of electrode nor, therefore, to align such masks precisely one with respect to another.

It is relatively easy to fabricate a very fine or small transistor using a self-alignment technique, and fabrication costs are relatively reduced.

Reference is made, by way of example, to the accompanying drawings, in which:—

Figure 1 is a schematic cross-sectional view of main parts of a self-aligned transistor as previously fabricated,

Figure 2 is a schematic cross-sectional view of main parts of a transistor embodying the present invention, and

Figure 3(a) to (i) are schematic cross-sectional views illustrating stages in a method of fabricating a transistor in accordance with an embodiment of the present invention.

In Figure 2, which shows a transistor embodying the present invention, parts like or corresponding to parts in Figure 1 are designated by the same reference numerals.

As compared with Figure 1, the transistor of Figure 2 is provided with a silicon nitride film 11, covering the periphery of base-emitter junction $J_f$.

The silicon nitride film is dense and stable as compared with thermally oxidised polysilicon. Moreover a silicon nitride film, chemically deposited from pure material, does not contain the dopant (impurity) which is contained in the base contact electrode material (polysilicon). The state of the surface covered by silicon nitride film is inherently more stable than the state of that surface (not covered by silicon nitride film) in the transistor of Figure 1, and improvements are afforded in respect of the leakage current and the break down voltage between base and emitter.

The transistor of Figure 2 is an iso-planar self-aligned bipolar transistor.

Concerning self-alignment attention is directed to, for example, U.S. Pat. No. 4,157,269 issued to T. H. Ning, H. N. Yu on June 5, 1979; and IEEE vol. ED-28, No. 9. 1981, PP. 1010—1013 by T. H. Ning et al.

In the transistor of Figure 2, the silicon nitride film 11 covers and protects the periphery of the base-emitter junction $J_f$ from the porous silicon dioxide layer 9 of polysilicon at the surface of substrate.

In more detail, the transistor of Figure 2 is fabricated with a n type collector region 3, which is made of a n type epitaxial layer, separated from neighboring regions (not shown) by a field oxide layer 4.

In the upper part of the collector region 3, a $p^+$ type base contact area 5, the depth of which is about 400—500 nm (4000 to 5000 A°), a p type active base region 6, the thickness of which is about 300 nm (3000 A°), and a $n^+$ type emitter region 7, the depth of which is about 2000 A°, are formed using conventional self-alignment techniques.

A thin silicon nitride ($Si_3N_4$) film 11, the thickness of which is 10—20 nm (100 to 200 A°) for example, is fabricated so as to cover the perimeter of base-emitter junction $J_f$ formed between the p type active base region 6 and the $n^+$ type emitter region 7.

Silicon dioxide layer 9 of thermally oxidised polysilicon terminates on the film 11. This layer 9 is formed at the surface of polysilicon layer 8, which latter layer is highly doped with p type conductivity impurity to form a base contact 8.

The silicon dioxide layer 9 separates emitter electrode 10, which is formed of aluminium for example, on the surface of the $n^+$ emitter region 7, from the above-mentioned polysilicon base electrode 8.

In Figure 2, 1 and 2 are a p type silicon substrate and a $n^+$ type buried layer respectively. Figure 2 shows only main parts of the transistor for the sake of simplicity. A collector contact, for example, is not shown in the Figure. Such a contact would be fabricated in a proper position outside of Figure 1 by conventional Iso planar technology.

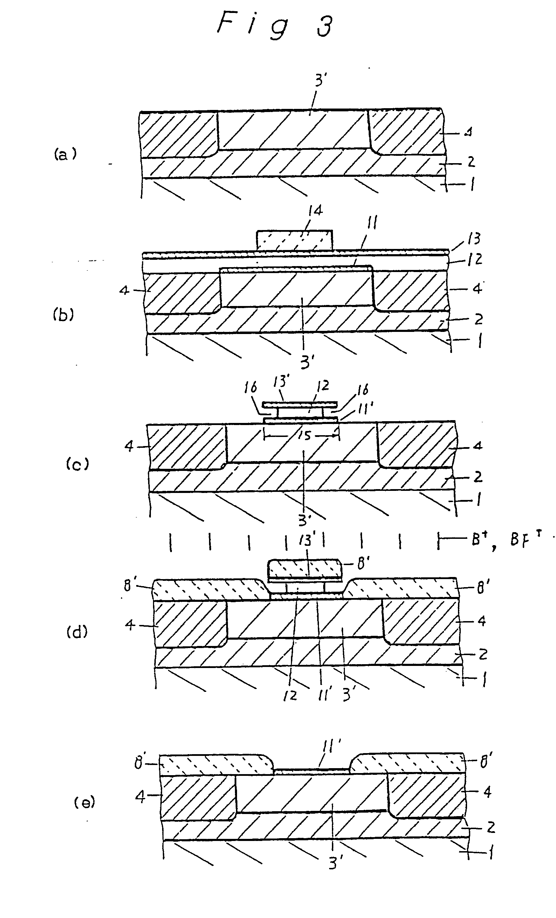

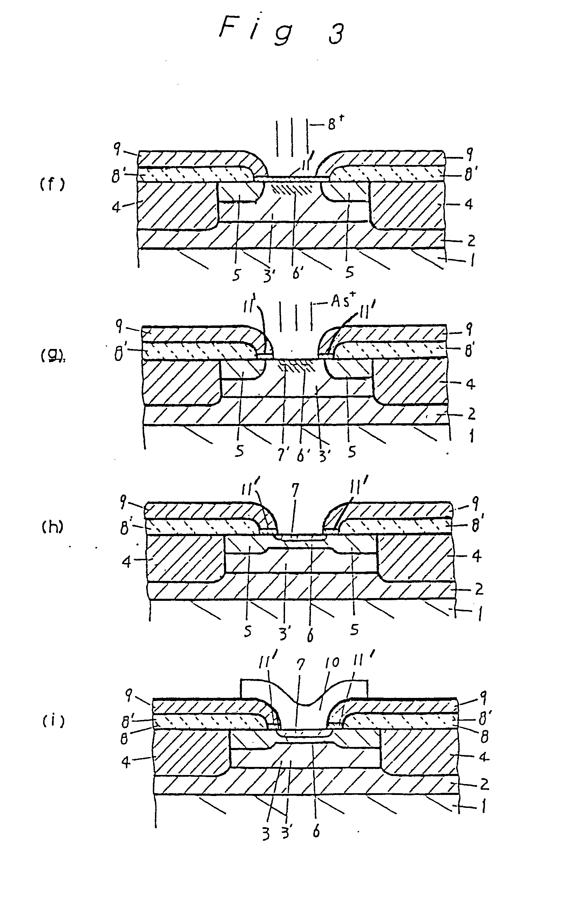

It should be also added that although Figure 2 and the explanation thereof refer to the use of a p type substrate as an example, substrates of a different conductivity type can be used provided that the dopants and materials of base and emitter are altered to afford conductivity types opposite to those mentioned in the above explanation. This applies also to the explanation given below concerning Figures 3(a) to (i).

A method of fabricating a transistor in accordance with an embodiment of the present invention will now be explained with reference to Figure 3(a) to (i).

In this case, as in an ordinary process for fabricating an Iso planar transistor, a p type silicon substrate 1 is used, as shown in Figure 3(a). On the substrate 1, a $n^+$ type buried layer 2 and n type epitaxial layer 3' are formed in order, respectively by diffusion and epitaxial growth. The epitaxial layer 3' is separated from neighboring such layers (not shown) by a field oxide layer 4.

Sometimes a $n^+$ collector contact region is fabricated in the separation region (the field oxide layer region in Figure 3(a)) in order to operationally connect the buried layer 2 to a collector contact fabricated on the surface of device. However, details of such an arrangement are omitted from the Figures for the sake of simplicity.

The substrate is then treated in ammonia gas ($HNO_3$) at a pressure of about 13.33—1333.2 Pa (0.1 to 10 Torr) and a temperature of about 1050°C for about 100 to 200 minutes, under the application of high frequency power at about 13.56 MHz. This treatment is called a direct nitridation process. More details of such a process are disclosed in "Semiconductor Technologies" (pp. 69 to 81) by T. Ito, published by Ohm & North Holland, 1982.

By this treatment, a thin silicon nitride film 11, the thickness of which is 10—20 nm (100 to 200 A°), is formed on the exposed silicon surface (the exposed surface of layer 3') as shown in Figure 3(b). This direct nitrided silicon 11 is called hereinafter a first silicon nitride film.

Next, by conventional chemical vapour deposition, a first silicon dioxide ($SiO_2$) layer 12, the thickness of which is about 300—500 nm (3000 to 5000 A°), and a second silicon nitride film 13, the thickness of which is about 30—100 nm (300 to 1000 A°), are deposited in order on the substrate, as shown in Figure 3(b).

Next, as shown in Figure 3(b), by conventional photo-lithography, a predetermined resist pattern 14 is formed on the second silicon nitride film 13, at a place corresponding to a location where an emitter region is to be formed.

It should be noted that the lithographic mask used for patterning the above-mentioned resist pattern 14 is the only mask necessary for the following processes. That is, the emitter and base regions of the transistor, their contact areas and contact electrodes, are all fabricated without need for further masks. Thus, mutual mask alignment is unnecessary, the processes are self aligned.

The second silicon nitride film 13, outside the resist pattern 14, is etched off by conventional reactive ion etching. By this process the first silicon dioxide film, outside the pattern 14, is exposed. This step is not specifically shown in the Figures.

Then making use of the thus patterned second silicon nitride film 13' as a mask, the exposed first silicon dioxide film is selectively etched off by wet eching as shown in Figure 3(c). For this etching, a process which causes side etching is preferable.

To this end, wet etching for example by hydrofluoric acid (HF) is applicable.

The above-mentioned etching process results in the first silicon dioxide film, where covered by the second silicon nitride film pattern 13', being side etched. The side-etched first silicon dioxide film can be seen at 12 in Figure 3(c). The width or extent of the side etching 16 (that is, the depth to which the first silicon dioxide film is laterally etched inwardly of second silicon nitride film 13' is approximately 300—500 nm (3000 to 5000 A°).

By making further use of the resist pattern 14 on the second silicon nitride film or pattern 13' as a mask (in Figure 3(c) the resist pattern 14 is omitted to avoid confusion), those parts of the first silicon nitride film 11 which are exposed (e.g. uncovered and unshadowed by the second silicon nitride pattern 13') are selectively etched off by reactive ion etching. Reactive ion etching is highly directive, and does not cause side etching to any substantial extent. Thus, the etched first silicon nitride film 11' is patterned by the etching to take a form corresponding in substance to that of the second silicon nitride pattern 13'. Then, the resist pattern 14 on the second silicon nitride pattern 13' is removed. This is shown in Figure 3(c).

In the following process a region designated by the reference numeral 15 in Figure 3(c) becomes an active base region, and the first silicon nitride film or pattern 11' becomes a film which covers the surface of the base region.

A polysilicon layer 8' the thickness of which is for example 300—500 nm (3000 to 5000 A°) is deposited as shown in Figure 3(d). By this deposition the second silicon nitride pattern 13' and areas outside that pattern (that is, the surface of epitaxial buried layer 3' outside the first silicon nitride pattern 11', and the surface of the field oxide layer 4) are covered by polysilicon as shown in Figure 3(d).

For depositing the polysilicon, it is desirable to use a process which does not result in lateral deposition (i.e. which does not result in deposition in areas of the deposition surface which are shadowed by an overlying layer) in order to prevent the over etched portion of the first silicon dioxide film 12 from being buried, as shown in the Figure 3(d). For this purpose a process for spattering or evaporating polysilicon material is for example applicable.

Next, a high dose (about $10^{16}$ atm/cm²) of boron ions ($B^+$) or ions of boron difluoride ($BF^+$) are implanted in the polysilicon layer 8' by ion implantation, changing the polysilicon layer 8' to highly doped polysilicon.

Next, the first silicon dioxide film 12 remaining between the two silicon nitride patterns 11' and 13' is removed by wet etching using, for example, hydrofluoric acid HF. By this etching process, the second silicon nitride pattern 13' and polysilicon 8' over the first silicon dioxide film 12 are lifted off. Thus, as shown in Figure 3(e), the first silicon nitride pattern 11' is exposed in an opening in highly doped polysilicon layer 8'.

In a next process the substrate is heated in an oxide atmosphere (it may be dry or wet oxygen) at a temperature of approximately 1000°C. The surface of the polysilicon layer 8' is oxidized selectively to form a thermal oxide layer 9 of about 300—500 nm (3000 to 5000 A°) thickness.

At the same time the dopant implanted in polysilicon layer 8' (that is boron) is diffused into n type epitaxial buried layer 3' to form a p$^+$ type base contact area 5, whose thickness is about 400—500 nm (4000 to 5000 A°), as shown in Figure 3(f). Sometimes this type of diffusion is called as solid-to-solid diffusion.

Next, boron is implanted through the first silicon nitride film 11 into the n type epitaxial layer 3', at 30 40 KeV to a dose of about $10^{14}$ atm/cm². In this ion implantation process the thermal silicon dioxide layer 9 is used as a mask. The boron is implanted selectively into the n type epitaxial layer. In Figure 3(f) a hatched zone 6' indicates the region into which boron is implanted.

Next, the first silicon nitride film 11', which is exposed in the region restricted by the thermal oxide layer 9, is selectively etched off, by reactive ion etching or by wet etching with heated phosphoric acid (H$_3$PO$_4$) for example. By this process, the first silicon nitride film 11' is left in place at the periphery of base contact area 5, as shown in Figure 3(g), terminating the silicon dioxide layer 9.

Arsenic ions (As$^+$), at a dose of about $10^{15}$ to $10^{16}$ atm/cm², are implanted into the upper region 7' of the boron implanted region 6', as shown in Figure 3(g).

After the implantation, the substrate is annealed as usual for an ion implantation process. By this annealing, the implanted impurities (that is boron and arsenic) are redistributed. By the difference of the depth of the distribution, and the difference of the diffusion constant, of each dopant, a p type active base region 6 of which the depth is about 300 nm (3000 A°) for example, and a n$^+$ type emitter region 7, of which the depth is about 200 nm (2000 A°), are provided.

Also by this annealing each dopant is diffused so that the active base region 6 extends to contact the base contact area 5. The emitter region also extends to beneath the first silicon nitride film 11, as shown in Figure 3(h). Thus the base-emitter junction is protected under the silicon nitride film 11.

Finally as shown in Figure 3(i), an emitter contact electrode 10, made of silicon aluminium alloy for example, is fabricated on the emitter surface. The base contact electrode is provided by the highly doped silicon layer 8'. The base and emitter electrodes are separated from each other by the silicon dioxide layer 9.

Though it is not shown in the Figures and not explained in the above disclosure, a collector electrode and wirings therefor are fabricated each in proper position by conventional means, and a passivation film provided on the surface of the device.

As can be seen from the above explanation, for fabrication of base, emitter, and their contact electrodes only the mask used for patterning the resist pattern 14 in Figure 3(b) is employed. No other mask is necessary. The electrodes are thus all self aligned.

The method described with reference to Figure 3 is convenient for fabricating fine patterns for ICs, it gives a high manufacturing yield, and the base-emitter junction of a transistor is protected by silicon nitride film to stabilise performance and offer a high breakdown voltage.

As can be seen in the above explanation relating to a self-aligned transistor embodying the present invention, the periphery of the base-emitter junction of the transistor is covered and protected by a silicon nitride film. Preferably, that film is deposited by a direct nitridation process.

Such a direct nitrided silicon film contains substantially no impurities, so its surface state is stable. It is dense as compared to silicon dioxide film. Moreover, it is an excellent isolation film, being waterproof and chemically stable.

Therefore, the present invention can provide a high quality and highly reliable self aligned transistor as compared with a self-aligned transistor as previously fabricated with a structure in which the periphery of base-emitter junction is covered by an oxide layer of porous polysilicon.

It will be clear that embodiments of the present invention can be applied not only to Iso planar structure transistors but also to LOCOS isolation transistors and conventional diffusion isolated transistors. It can be applied to both npn and pnp type transistors.

An embodiment of an aspect of the present invention provides a semiconductor device which comprises:

a) base contact area;

b) active base region connected to said base contact area;

c) emitter fabricated in said active base region;

d) base contact electrode made of polysilicon, fabricated on said base contact area; and

e) silicon nitride film covering the periphery of base-emitter junction on the surface of substrate; said base and said emitter are isolated each other by surface oxidised layer of said polysilicon base contact, and said oxide layer being terminated on said silicon nitride film.

**Claims**

1. A semiconductor device, comprising
   an active base region (6),
   an emitter region (7) formed in the active base region (6), to provide a base-emitter junction (J$_f$) having a perimeter at a surface in the device, and
   a silicon nitride film (11, 11') formed on the surface to cover the perimeter of the base-emitter junction (J$_f$),
   characterised by a base contact area (5) connected to the active base region (6), a base contact electrode (8, 8'), of polysilicon, formed on the base contact area, and an oxide layer (9) formed by surface oxidation of the base contact electrode (8, 8'), for isolating the base contact electrode (8, 8') from an emitter electrode (10), the oxide layer (9) terminating on the silicon nitride film (11, 11').

2. A device as claimed in claim 1, wherein the emitter region (7) is exposed at the said surface, surrounded by the nitride film (11, 11') covering the perimeter of the base-emitter junction $(J_f)$, and the emitter electrode (10) contacts the emitter region (7) where exposed within the nitride film (11, 11').

3. A device as claimed in claim 1, wherein the base contact electrode (8, 8') contacts the base contact area (5) outside the nitride film (11, 11').

4. A device as claimed in any preceding claim, in which the base contact area (5) is a self aligned base contact area.

5. A device as claimed in any preceding claim, in which the active base region (6) is a self aligned active base region.

6. A semiconductor device as claimed in claim 1, in which the emitter region (7) is a self aligned emitter region.

7. A device as claimed in any preceding claim, being a self aligned transistor.

8. A device as claimed in any preceding claims, being a silicon transistor.

9. A device as claimed in claim 8, wherein the nitride film (11, 11') is formed by direct nitridation.

10. A method of fabricating a semiconductor device having an emitter electrode (10) separated from a base contact electrode (8, 8'), of polysilicon, by a thermally oxidised polysilicon layer (9); the method comprising the following steps:—

a) coating a surface of a first conductivity type region of the device with a first silicon nitride film (11);

b) forming, in turn, on the surface of the first silicon nitride film (11), a first silicon dioxide film (12) and a second silicon nitride film (13);

c) patterning the second silicon nitride film (13) to expose a part of the first silicon dioxide film (12);

d) etching off the exposed part of the first silicon dioxide film (12), to thereby expose part of the first silicon nitride film (11), at the same time side etching the first silicon dioxide film beneath the patterned second silicon nitride film (13');

e) etching off the exposed part of first silicon nitride film which is not beneath the patterned second silicon nitride film (13');

f) providing a highly doped polysilicon layer (8') of a second conductivity type on the surface of the patterned second silicon nitride film (13') and on surface parts of the said device region that are exposed in step e);

g) etching off the remainder of the first silicon dioxide film, at the same time lifting off the patterned second silicon nitride film (13') and the part of the polysilicon layer (8') thereon;

h) providing by thermal oxidation a silicon dioxide layer (9) on the surface of the remaining part of the polysilicon layer (8'), and terminating on the first silicon nitride film (11'), at the same time diffusing impurities from the polysilicon layer (8') into the said device region of the first conductivity type, to provide a base contact region (5) of the second conductivity type;

i) selectively implanting impurities of the second conductivity type, by ion implantation, through the first silicon nitride film (11'), into the said device region using as a mask the polysilicon layer (8') having the thermal oxidized silicon dioxide layer (9) thereon;

j) selectively etching off the first silicon nitride film (11') were exposed by the polysilicon layer (8') having the thermally oxidised silicon dioxide layer (9) thereon;

k) selectively implanting impurities of the first conductivity type by ion implantation into the zone of the said device region where impurities of the second conductivity type were implanted in step i), using as a mask the polysilicon layer (8') having the thermal oxidised silicon dioxide layer (9) thereon; and

l) annealing the ion implanted impurities of first and second conductivity types, by heat treatment, to form an active base region (6) which is of the second conductivity type and which extends to contact the base contact region (5), and an emitter region (7) of the first conductivity type which extends underneath the remaining part of the first silicon nitride film (11') so that the perimeter of the base-emitter junction $(J_f)$ at the surface of the said device region is covered by that remaining part of the first silicon nitride film.

11. A method as claimed in claim 10, wherein step a) is accomplished by a direct nitridation process.

12. A method as claimed in claim 10 or 11, wherein step b) is accomplished by chemical vapor deposition.

13. A method as claimed in claim 10, 11 or 12, wherein step f) is accomplished by evaporation or sputtering of polysilicon.

14. A method as claimed in claim 10, 11, 12, or 13, in which the base contact region (5) is provided in step h) by a solid to solid diffusion process.

15. A method as claimed in any preceding claims 10—14 wherein the said device region is of silicon.

**Patentansprüche**

1. Halbleitervorrichtung mit
einem aktiven Basisbereich (6),
einem Emitterbereich (7), der in dem aktiven Basisbereich (6) gebildet ist, um einen Basis-Emitter-Übergang $(J_f)$ zu bilden, der an einer Oberfläche der Vorrichtung einen Umfang hat, und
einem Siliziumnitridfilm (11, 11'), der auf der Oberfläche gebildet ist, um den Umfang des Basis-Emitter-Übergangs $(J_f)$ zu bedecken, gekennzeichnet durch:
einen Basiskontaktbereich (5), der mit dem aktiven Basisbereich (6) verbunden ist, eine Basiskontaktelektrode (8, 8') aus Polysilizium, die auf dem Basiskontaktbereich gebildet ist, und eine Oxidschicht (9), die durch Oberflächenoxidation der Basiskontaktelektrode (8, 8') gebildet ist, zur Isolierung der Basiskontaktelektrode (8, 8') von einer Emitterelektrode (10), wobei die Oxidschicht (9) auf dem Siliziumnitridfilm (11, 11') endet.

2. Vorrichtung nach Anspruch 1, bei welcher der Emitterbereich (7) an der genannten Oberfläche exponiert ist, von dem Nitridfilm (11, 11') umgeben ist, der den Umfang des Basis-Emitter-Übergangs ($J_f$) bedeckt, und die Emitterelektrode (10) den Emitterbereich (7), wo er innerhalb des Nitridfilms (11, 11') exponiert ist, kontaktiert.

3. Vorrichtung nach Anspruch 1, bei welcher die Basiskontaktelektrode (8, 8') den Basiskontaktbereich (5) außerhalb des Nitridfilms (11, 11') kontaktiert.

4. Vorrichtung nach einem der vorhergehenden Ansprüche, bei welcher der Basiskontaktbereich (5) ein selbstausgerichteter Basiskontaktbereich ist.

5. Vorrichtung nach einem der vorhergehenden Ansprüche, bei welcher der aktive Basisbereich (6) ein selbstausgerichteter aktiver Basisbereich ist.

6. Vorrichtung nach Anspruch 1, bei welcher der Emitterbereich (7) ein selbstausgerichteter Emitterbereich ist.

7. Vorrichtung nach einem der vorhergehenden Ansprüche, welche ein selbstausgerichteter Transistor ist.

8. Vorrichtung nach einem der vorhergehenden Ansprüche, welche ein Siliziumtransistor ist.

9. Vorrichtung nach Anspruch 8, bei welcher der Nitridfilm (11, 11') durch direkte Nitrierung gebildet ist.

10. Verfahren zur Herstellung einer Halbleitervorrichtung mit einer Emitterelektrode (10), die von einer Basiskontaktelektrode (8, 8'), aus Polysilizium, durch eine thermisch oxidierte Polysiliziumschicht (9) getrennt ist, welches Verfahren die folgenden Schritte umfaßt:—

a) Überziehen einer Oberfläche eines Bereichs von einem ersten Leitfähigkeitstyps der Vorrichtung mit einem ersten Siliziumnitridfilm (11);

b) Bildung, der Reihe nach, eines ersten Siliziumdioxidfilms (12) und eines zweiten Siliziumnitridfilms (13) auf der Oberfläche des ersten Siliziumnitridfilms (11);

c) Musterung des zweiten Siliziumnitridfilms (13), um einen Teil des ersten Siliziumdioxidfilms (12) zu exponieren;

d) Wegätzen des exponierten Teils des ersten Siliziumdioxidfilms (12), um dadurch einen Teil des ersten Siliziumnitridfilms (11) zu exponieren, bei gleichzeitiger Seitenätzung des ersten Siliziumdioxidfilms unterhalb des gemusterten zweiten Siliziumnitridfilms (13');

e) Wegätzen des exponierten Teils des ersten Siliziumnitridfilms, der nicht unterhalb des gemusterten zweiten Siliziumnitridfilms (13') ist;

f) Bildung einer hochdotierten Polysiliziumschicht (8') von einem zweiten Leitfähigkeitstyp auf der Oberfläche des gemusterten zweiten Siliziumnitridfilms (13') und auf Oberflächenteilen des genannten Vorrichtungsbereichs, die beim Schritt e) exponiert werden;

g) Wegätzen des Restes des ersten Siliziumdioxidfilms, bei gleichzeitigem Abheben des gemusterten zweiten Siliziumnitridfilms (13) und des Teils der Polysiliziumschicht (8') auf diesem;

h) Bildung einer Siliziumdioxidschicht (9), durch thermische Oxidation, auf der Oberfläche des verbleibenden Teils der Polysiliziumschicht (8') und endend auf dem ersten Siliziumnitridfilm (11'), bei gleichzeitiger Diffusion von Verunreinigungen von der Polysiliziumschicht (8') in den genannten Vorrichtungsbereich von dem ersten Leitfähigkeitstyp, um einen Basiskontaktbereich (5) von dem zweiten Leitfähigkeitstyp zu bilden;

i) selektives Implantieren von Verunreinigungen von dem zweiten Leitfähigkeitstyp, durch Ionenimplantation, durch den ersten Siliziumnitridfilm (11'), in den genannten zweiten Vorrichtungsbereich, unter Verwendung der Polysiliziumschicht (8'), auf der die thermisch oxidierte Siliziumdioxidschicht (9) ist, als eine Maske;

j) selektives Wegätzen des ersten Siliziumnitridfilms (11'), wo dieser durch die Polysiliziumschicht (8'), welche die thermisch oxidierte Siliziumdioxidschicht (9) trägt, exponiert ist;

k) selektives Implantieren von Verunreinigungen von dem ersten Leitfähigkeitstyp durch Ionenimplantation in die Zone des genannten Vorrichtungsbereichs, wo Verunreinigungen von dem zweiten Leitfähigkeitstyp während des Schrittes i) implantiert worden sind, unter Verwendung der Polysiliziumschicht (8'), die die thermisch oxidierte Siliziumdioxidschicht (9) trägt, als eine Maske; und

l) Annealbehandlung der ionenimplantierten Verunreinigungen von dem ersten und dem zweiten Leitfähigkeitstyp, durch Wärmebehandlung, um einen aktiven Bereich (6) zu bilden, der von dem zweiten Leitfähigkeitstyp ist und der sich zur Kontaktierung mit dem Basiskontaktbereich (5) erstreckt, und einen Emitterbereich (7) von dem ersten Leitfähigkeitstyp, der sich unterhalb des verbleibenden Teils des ersten Siliziumnitridfilms (11') so erstreckt, daß der Umfang des Basis-Emitter-Übergangs ($J_f$) an der Oberfläche des genannten Vorrichtungsbereichs durch den verbleibenden Teil des ersten Siliziumnitridfilms bedeckt ist.

11. Verfahren nach Anspruch 10, bei welchem der Schritt a) durch einen direkten Nitrierungsprozeß durchgeführt wird.

12. Verfahren nach Anspruch 10 oder 11, bei welchem der Schritt b) durch chemische Abscheidung aus der Dampfphase bewirkt wird.

13. Verfahren nach Anspruch 10, 11 oder 12, bei welchem der Schritt f) durch Verdampfen oder Sputtern von Polysilizium bewirkt wird.

14. Verfahren nach Anspruch 10, 11, 12 oder 13, bei welchem der Basiskontaktbereich (5) bei dem Schritt h) durch einen Festkörper-zu-Festkörper-Diffusionsprozeß gebildet wird.

15. Verfahren nach einem der vorhergehenden Ansprüche 10 bis 14, bei welchem der genannte Vorrichtungsbereich aus Silizium besteht.

**Revendications**

1. Composant semi-conducteur, comportant: une région de base active (6), une région d'émetteur (7) formée dans la région de base active (6) pour réaliser une jonction base émetteur ($J_f$) ayant un périmètre à une surface dans le composant et une pellicule de nitrure de silicium (11, 11') formée sur la surface pour recouvrir le périmètre de la jonction base-émetteur ($J_f$), caractérisé en ce qu'il comporte une surface de contact de base (5) connectée à la région de base active (6), une électrode de contact de base (8, 8') de polysilicium formée sur la surface de contact de base et une couche d'oxyde (9) formée par oxydation superficielle de l'électrode de contact de base (8, 8') pour isoler l'électrode de contact de base (8, 8') d'une électrode d'émetteur (10), la couche d'oxyde (8) se terminant sur la pellicule de nitrure de silicium (11, 11').

2. Composant selon la revendication 1, dans lequel la région d'émetteur (7) est exposée à ladite surface, entourée par la pellicule de nitrure (11, 11') recouvrant le périmètre de la jonction base-émetteur ($J_f$) et l'électrode d'émetteur (10) étant en contact avec la région d'émetteur (7) où elle est exposée dans la pellicule de nitrure (11, 11').

3. Composant selon la revendication 1, dans lequel l'électrode de contact de base (8, 8') est en contact avec la surface de contact de base (5) à l'extérieur de la pellicule de nitrure (11, 11').

4. Composant selon l'une quelconque des revendications précédentes, dans lequel la surface de contact de base (5) est une surface de contact de base auto-alignée.

5. Composant selon l'une quelconque des revendications précédentes, dans lequel la région de base active (6) est une région de base active auto-alignée.

6. Composant semi-conducteur selon la revendication 1, dans lequel la région d'émetteur (7) est une région d'émetteur auto-alignée.

7. Composant selon l'une quelconque des revendications précédentes, consistant en un transistor auto-aligné.

8. Composant selon l'une quelconque des revendications précédentes, consistant en un transistor au silicium.

9. Composant selon la revendication 8, dans lequel la pellicule de nitrure (11, 11') est formée par nitruration directe.

10. Procédé de fabrication d'un composant semi-conducteur comprenant une électrode d'émetteur (10) séparée d'une électrode de contact de base (8, 8') en polysilicium par une couche (9) oxydée thermiquement; le procédé consistant essentiellement:

a) à revêtir une surface d'une région d'un premier type de conductivité du composant avec une première pellicule de nitrure de silicium (11);

b) à former à son tour sur la surface de la première pellicule de nitrure de silicium (11) une première pellicule de bioxyde de silicium (12) et une seconde pellicule de nitrure de silicium (13);

c) à mettre en forme la seconde pellicule de nitrure de silicium (13) pour exposer une partie de la première pellicule de bioxyde de silicium (12);

d) à éliminer par gravure la partie exposée de la première pellicule de bioxyde de silicium (12) afin d'exposer une partie de la première pellicule de nitrure de silicium (11) et à attaquer en même temps latéralement la première pellicule de bioxyde de silicium au-dessous de la seconde pellicule de nitrure de silicium (13') mise en forme;

e) à éliminer par gravure la partie exposée de la première pellicule de nitrure de silicium qui n'est pas audessous de la seconde pellicule de nitrure de silicium (16') mise en forme;

f) à former une couche (8') de polysilicium fortement dopé d'un second type de conductivité sur la surface de la seconde pellicule de nitrure de silicium (13') mise en forme et sur des parties de surface de ladite région du composant qui sont exposées au cours de la phase e);

g) à éliminer par gravure le reste de la première pellicule de bioxyde de silicium tout en éliminant en même temps la seconde pellicule de nitrure de silicium (13') mise en forme et la partie de la couche de polysilicium (8') au-dessus d'elle;

h) à former par oxydation thermique une couche de bioxyde de silicium (9) sur la surface de pa partie qui reste de la couche de polysilicium (8') et se terminant sur la première pellicule de nitrure de silicium (11') et en même temps à diffuser des impuretés depuis la couche de polysilicium (8') dans ladite région du composant du premier type de conductivité pour former une région de contact de base (5) du second type de conductivité;

i) à implanter sélectivement des impuretés du second type de conductivité par implantation d'ions à travers la première pellicule de nitrure de silicium (11') dans ladite région du composant en utilisant comme un masque la couche de polysilicium (8') portant la couche de bioxyde de silicium (9) oxydée thermiquement;

j) à éliminer sélectivement par gravure la première pellicule de nitrure de silicium (11') où elle est exposée par la couche de polysilicium (8') portant la couche de bioxyde de silicium (9) oxydée thermiquement;

k) à implanter sélectivement des impuretés du premier type de conductivité par implantation d'ions dans la zone de ladite région du composant où des impuretés du second type de conductivité ont été implantées à la phase i), en utilisant comme un masque la couche de polysilicium (8') portant la couche de bioxyde de silicium (9) oxydée thermiquement; et

l) à recuire le impuretés implantées par ions du premier et du second types de conductivité par traitement thermique pour former une région de base active (5) qui est du second type de conductivité et qui s'étend jusqu'au contact avec la région de contact de base (5) et une région d'émetteur (7) du premier type de conductivité qui s'étend au-dessous de la partie qui reste de la première pellicule de nitrure de silicium (11') de manière que le périmètre de la jonction base-émetteur ($J_f$) à la surface de ladite région du composant soit recouverte par la partie qui reste de la première pellicule de nitrure de silicium.

11. Procédé selon la revendication 10, dans lequel la phase a) est effectuée par une opération de nitruration directe.

12. Procédé selon la revendication 10 ou 11, dans lequel la phase b) est effectuée par dépôt de vapeur chimique.

13. Procédé selon la revendication 10, 11 ou 12 dans lequel la phase f) est effectuée par évaporation ou pulvérisation de polysilicium.

14. Procédé selon la revendication 10, 11, 12, ou 13 dans lequel la région de contact de base (5) est formée au cours de la phase h) par un procédé de diffusion solide-solide.

15. Procédé selon l'une quelconque des revendications 10 à 14 dans lequel ladite région du composant est en silicium.

## Fig 1

## Fig 2

1

# Fig 3

(a)

(b)

(c)

(d)

$B^+$, $BF^+$

(e)

**0 109 766**

Fig 3

(f)

(g)

(h)

(i)